# EUROPÄISCHE PATENTANMELDUNG

(11) **EP 1 010 582 A2**
(43) Veröffentlichungstag der Anmeldung: **21.06.2000**
(21) Anmeldenummer: 99123262.0
(22) Anmeldetag: 29.11.1999
(51) Int. Cl.: B60R 16/02

(54) **Elektronische Einrichtung**

(30) Priorität: 15.12.1998 DE 19857840
(71) Anmelder: Mannesmann VDO Aktiengesellschaft, 60388 Frankfurt am Main (DE)
(72) Erfinder: Wiezorek, Hans-Werner, 65817 Eppstein (DE); Wolf, Barbara, 65824 Schwalbach (DE)
(74) Vertreter: Klein, Thomas, Dipl.-Ing.

(57) **Zusammenfassung**

Die Erfindung betrifft eine elektronische Einrichtung für ein Kraftfahrzeug, welche in einem zweiteiligen Gehäuse eine zum Schalten hoher Ströme ausgebildete Elektronikeinheit aufweist, wobei zur Unterdrückung der dadurch hervorgerufenen Störsignale eine Kondensatoreinheit im Gehäuse angeordnet ist.

Bei einer elektronischen Einrichtung, welche einfach herstellbar ist und bei welcher die von den elektronischen Schaltungen erzeugte Wärme die Funktion der elektronischen Schaltung nicht weiter beeinflußt, ist die großflächig ausgebildete Kondensatoreinheit wärmetechnisch mit einem ersten Gehäuseteil (1) und die Elektronikeinheit (8, 9) wärmetechnisch mit einem zweiten Gehäuseteil (2) verbunden.

## Beschreibung

Die Erfindung betrifft eine elektronische Einrichtung für ein Kraftfahrzeug, welche in einem zweiteiligen Gehäuse eine zum Schalten hoher Ströme ausgebildete Elektronikeinheit aufweist, wobei zur Unterdrückung der durch die hohen Ströme hervorgerufenen Störsignale eine Kondensatoreinheit vorhanden ist.

Es sind Steuergeräte bekannt, welche neben der Steuerelektronik auch eine Leistungsendstufe zur Ansteuerung eines Stellgliedes im Kraftfahrzeug enthalten. Bei der Ansteuerung des Stellgliedes, wie beispielsweise eines Elektromotors für Fensterheber oder zur Realisierung eines Ventilhubes in einem Kraftfahrzeug werden durch die Leistungsendstufen hohen Ströme bereitgestellt. Im Falle einer getakteten Ansteuerung werden durch das Schalten der hohen Ströme Störsignale innerhalb des Steuergerätes erzeugt, deren Pegel um ein Vielfaches größer sind als die Pegel der Signale, welche die Steuerelektronik verarbeitet. Durch die räumlich dichte Anordnung dieser unterschiedlichen Schaltungen in einem Steuergerät werden die Signale der Steuereinrichtung durch diese elektromagnetischen Störsignale beeinflußt. Um die elektromagnetische Verträglichkeit dieser beiden Anordnungen herzustellen, sind in den Steuergeräten Kondensatoren elektrisch verschaltet, welche die Störsignale kompensieren.

Sowohl die Leistungselektronik als auch die Kondensatoren erzeugen im Betrieb eine hohe Verlustwärme, welche über das Gehäuse an die Umgebung abgegeben wird.

Dabei sind umfangreiche konstruktive Gestaltungen des Gehäuses in Form von Kühlrippen notwendig, um die entstehende Wärme schnell abzuführen.

Der Erfindung liegt die Aufgabe zugrunde, eine elektronische Einrichtung anzugeben, welche einfach herstellbar ist und bei welcher die von den elektronischen Schaltungen erzeugte Wärme die Funktion der elektronischen Schaltungen nicht weiter beeinflußt.

Erfindungsgemäß ist die Aufgabe dadurch gelöst, daß die großflächig ausgebildete Kondensatoreinheit wärmetechnisch mit einem ersten Gehäuseteil und die Elektronikeinheit wärmetechnisch mit einem zweiten Gehäuseteil verbunden sind.

Der Vorteil der Erfindung besteht darin, daß die beiden, Verlustwärme unterschiedlicher Stärke erzeugenden Komponenten wärmetechnisch entkoppelt sind. Die Gestaltung des Kühlkörpers jedes Gehäuseteiles kann den spezifischen Gegebenheiten angepaßt werden.

In einer Ausgestaltung ist die modulare Kondensatoreinheit in eine modulartig ausgebildete Steckereinheit einlegbar, welche an dem ersten Gehäuseteil befestigt ist. Durch die modulartige Gestaltung sowohl der Kondensatoreinheit als auch der Steckereinheit ist eine einfache Montage im Gehäuse möglich. Bei der Kondensatoreinheit wird vollständig auf separate Befestigungsmittel verzichtet. Sie wird mit der Steckereinheit am Gehäuse arretiert.

Zur Stabilisierung der Lage der Kondensatoreinheit ist diese durch ein sich an dem zweiten Gehäuseteil abstützendes Federelement gegen das erste Gehäuseteil vorgespannt. Außerdem wird aufgrund dieser Anordnung die Kondensatoreinheit unempfindlich gegenüber Fahrzeugschwingungen. Fahrzeugbewegungen haben keinen Einfluß auf die elektrischen Verbindungen der Kondensatoreinheit. Kurzschlüsse werden somit sicher vermieden.

In einer anderen Ausgestaltung sind die Steckereinheit und die Kondensatoreinheit unabhängig voneinander an dem zweiten Gehäuseteil mechanisch befestigt. Auf Grund dieser Anordnung ist die Lage der Kondensatoreinheit stabil gegen Schwingungen, so daß auf zusätzliche Stabilisierungsmaßnahmen verzichtet werden kann.

Vorteilhafterweise ist zwischen der Kondensatoreinheit und dem ersten Gehäuseteil eine Wärmeleitkleberschicht angeordnet. Diese Wärmeleitkleberschicht überträgt nicht nur die von der Kondensatoreinheit erzeugte Wärme an das erste Gehäuseteil, sondern gleicht zusätzlich die große Toleranzlage des Kondensators innerhalb des Gehäuses aus.

In einer Ausgestaltung verlaufen nach außen geführte, einstückig ausgebildete Kontaktelemente der Steckereinheit unterhalb der Kondensatoreinheit und sind an einer dem Gehäuseinnenraum zugewandten Bondfläche mit den elektrischen Anschlüssen der Elektronikeinheit verbindbar. Insbesondere wenn die Kontaktelemente als Blechformteil ausgebildet sind, ist eine solche platzsparende Form leicht herstellbar.

Die Elektronikeinheit liegt zur wärmetechnischen Kopplung flächig auf dem zweiten, plattenähnlich gestalteten Gehäuseteil auf Damit wird der bestmögliche Wärmeaustausch zwischen Elektronik und dem Gehäuseteil erzielt.

Beide Gehäuseteile weisen eine rippenähnliche Außenoberfläche auf, die unterschiedlich stark ausgeprägt ist. Aufgrund der Anordnung der Kondensatoreinheit und der Elektronikeinheit in verschiedenen Gehäuseteilen ist auch eine Variation der Kühlrippen möglich, die somit optimal an die abzuführende Wärmemenge angepaßt werden kann, welche von der jeweiligen Einrichtung erzeugt wird.

In einer Ausgestaltung ist das erste Gehäuseteil zur formschlüssigen Aufnahme der die Kondensatoreinheit bildenden einzelnen Kondensatorelemente ausgebildet. Bei dieser Anordnung werden die Kondensatorelemente direkt auf das Gehäuseteil aufgelegt, wodurch ein unmittelbarer Wärmekontakt entsteht.

Insbesondere bei der Verwendung von handelsüblichen Kondensatorzellen weist die Innenfläche des ersten Gehäuseteiles der Außenkontur der Kondensatorelemente entsprechende halbkreisförmige Vertiefungen auf.

Die Kondensatorelemente bilden dabei zwei Bereiche, die durch Leitbleche getrennt sind, welche an unterschiedliche elektrische Potentiale angeschlossen sind. Durch diese Einrichtung werden umfangreiche Leitungsverbindungen für die Kondensatoren gespart.

Die Leitbleche sind dabei annähernd L-förmig ausgebildet, was einen platzsparenden Einbau ermöglicht.

Um eine möglichst kleine elektronische Einrichtung anzugeben, liegt das erste Gehäuseteil auf einem Hybridrahmen auf, welche mit dem zweiten, die Elektronikeinheit tragenden Gehäuseteil formschlüssig verbunden ist.

Die Erfindung weist zahlreiche Ausführungsformen auf. Zwei davon sollen anhand der in der Zeichnung dargestellten Figuren näher erläutert werden.

Es zeigt:
- Figur 1:: erste Ausführungsform der erfindungsgemäßen Einrichtung,
- Figur 2:: Draufsicht auf das erste Gehäuseteil,
- Figur 3:: Ausbildung des Steckermoduls,
- Figur 4:: zweite Ausführungsform der erfindungsgemäßen Einrichtung,
- Figur 5:: Schnitt durch die zweite Ausführungsform,
- Figur 6:: dritte Ausführungsform der erfindungsgemäßen Einrichtung,
- Figur 7:: Draufsicht auf das erste Gehäuseteil,
- Figur 8:: Ansicht des verschlossenen Gehäuses,
- Figur 9:: Anordnung der Kondensatoreinheit in der zweiten erfindungsgemäßen Ausführungsform.

Gleiche Merkmale sind mit gleichen Bezugszeichen gekennzeichnet.

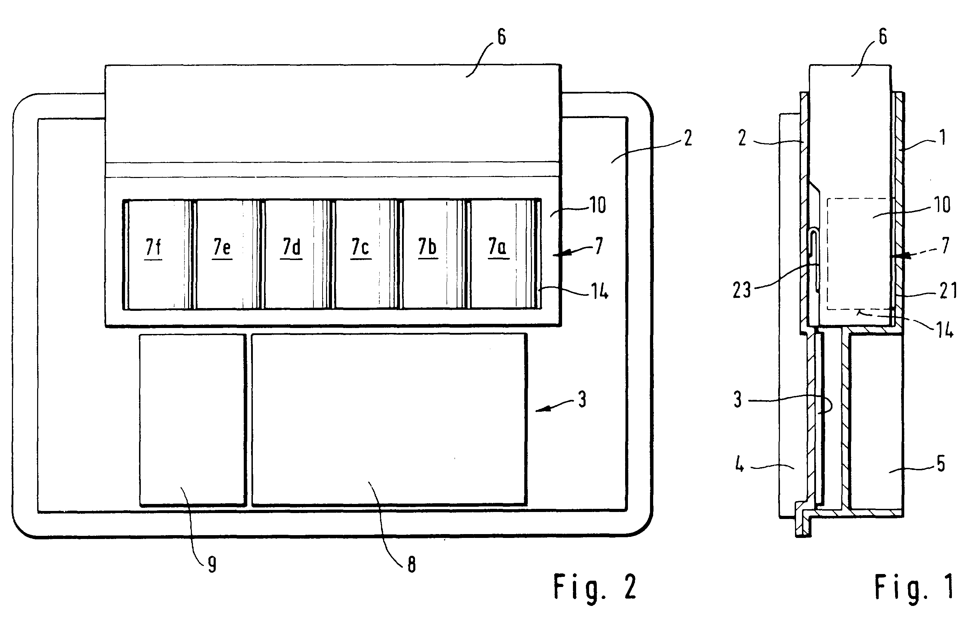

In Figur 1 ist der prinzipielle Aufbau der erfindungsgemäßen Einrichtung dargestellt, wie sie zur Ansteuerung eines Elektromotors verwendet wird, der den Ventilhub eines Lufteinlaßventiles eines Verbrennungsmotors einstellt. Es besteht aus zwei Gehäuseteilen 1 und 2, wobei auf dem zweiten Gehäuseteil 2 eine Hybridschaltung 3 angeordnet ist. An der Außenfläche des zweiten Gehäuseteiles 2 sind Kühlrippen 4 ausgebildet.

Auch das deckelartige Gehäuseteil 1 weist Kühlrippen 5 auf. Zwischen den Gehäuseteilen 1 und 2 ist ein Steckermodul 6 dichtend angeordnet. Das Steckermodul 6 trägt einen Kondensator 7, welcher in räumlicher Nähe zum Gehäuseteil 1 angeordnet ist.

Figur 2 zeigt eine Draufsicht auf das zweite Gehäuseteil 2 mit Steckereinrichtung 6 und einer Elektronik 8, 9. Auf dem Gehäuseteil 2 ist ein Prozessorhybrid 8 angeordnet, welches in Abhängigkeit des zu überwachenden Prozesses Steuersignale für ein Leistungsendstufenmodul 9 erzeugt, das nach Anforderung die entsprechenden Schaltspannungen bzw. -ströme für den Elektromotor generiert. Das Leistungsendstufenmodul 9 ist ebenfalls auf dem Gehäuseteil 2 positioniert.

Das Steckermodul 6 weist dabei einen Steckerkörper 10 auf, in welchem eine Ausnehmung 14 eingelassen ist. In diese Ausnehmung 14 werden handelsübliche Kondensatorzellen 7a bis 7f eingelegt.

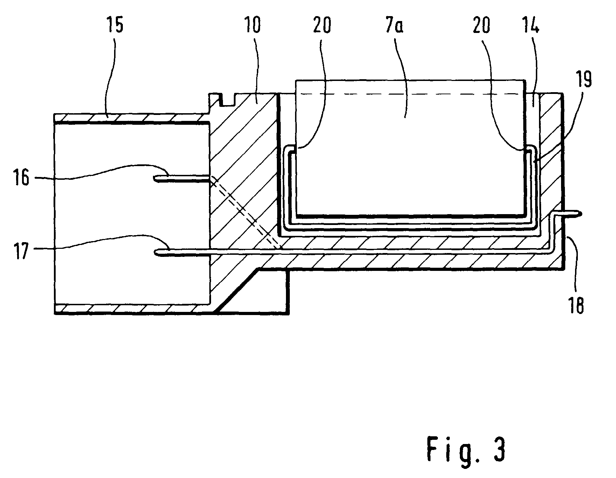

Die Steckereinheit 6 ist in Figur 3 näher erläutert. Wie daraus ersichtlich ist, ist der Steckerkörper 10 einstückig ausgebildet und weist einen Stekkereinlaß 15 auf, in welchen die Steckerelemente 16 und 17 hineinragen. Der Steckereinlaß 15 dient zur Aufnahme des Gegensteckers. Zur vereinfachten Darstellung sind hier nur zwei Steckerelemente 16, 17 gezeigt. Es ist aber auch eine Vielzahl von solchen Steckerelemente denkbar.

Die Steckerpins 16 und 17 sind vorteilhafterweise als Blechformteile ausgebildet, die in eine Spritzgußform eingelegt werden und mit einem Kunststoff umspritzt werden, wobei der Kunststoff dann gleichzeitig den Steckerkörper 10 bildet. Die zum Steckereinlaß 15 entgegengesetzt ausgebildete Fläche 18 dient dabei als Bondfläche zum Anschluß des Stekkerpins 17 an die Elektronik 8 und 9.

In der Ausnehmung 14 ist eine Kontakteinrichtung 19 für den Kondensator 7a eingelegt, welche zur Lagestabilisierung eingeklebt oder mechanisch gehalten wird. Zur sicheren Kontaktierung der Kondensatoren 7a bis 7f mit der Kontakteinrichtung 19 werden diese Kondensatoren 7a bis 7f mit dieser an den Schweißstellen 20 verschweißt.

Zwischen dem Gehäuseteil 1 und dem Kondensator 7 befindet sich eine Schicht aus Wärmeleitkleber 21, welche die Übertragung der von dem Kondensator 7 erzeugten Wärme auf den Aluminiumdeckel 1 gewährleistet. Auf dem zweiten, den Boden bildenden Gehäuseteil 2 ist eine Feder 22 angeordnet, welche den Teil des Steckerkörpers 10, welcher die Kondensatoren 7 trägt, gegen das erste Gehäuseteil 1 drückt (Figur 1).

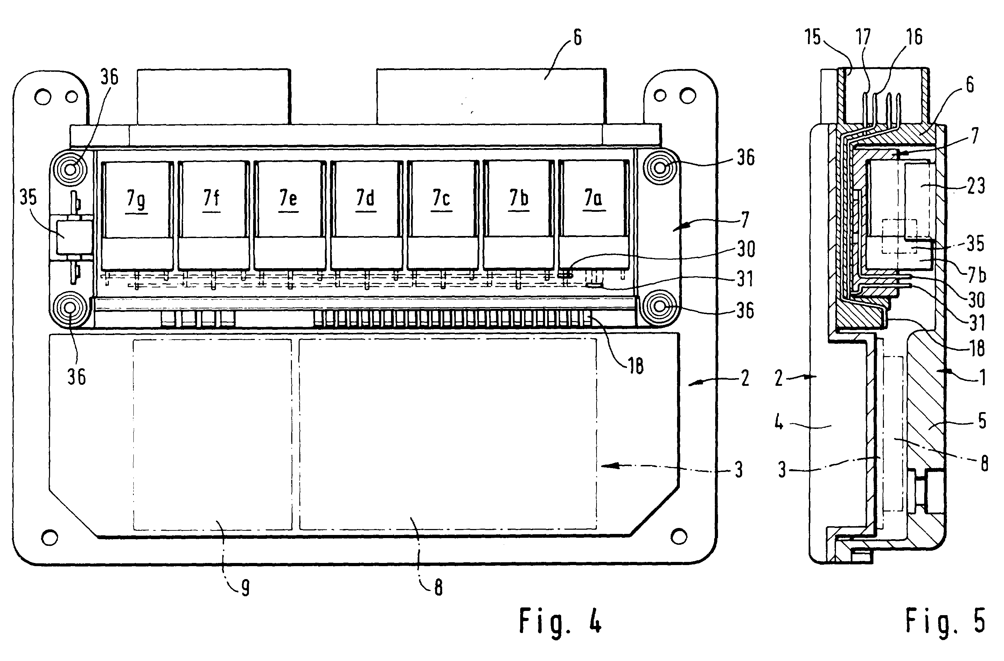

In Figur 4 ist eine zweite Ausführungsform der erfindungsgemäßen elektronischen Einrichtung dargestellt. Dabei sind das Steckerteil 6 und eine Kondensatoreinheit 7, in sieben Kondensatorelementen 7a bis 7g unabhängig voneinander gefertigt. Das Kondensatormodul 7 ist über Nietverbindungen 36 mit dem zweiten Gehäuseteil mechanisch verbunden. Dabei wird gleichzeitig die Steckereinheit 6 mechanisch am zweiten Gehäuseteil 2 arretiert. An der Kondensatoreinheit 7 ist weiterhin eine Z-Diode 35 zur Begrenzung von Spannungsspitzen angeordnet, welche ebenfalls gekühlt wird.

In der Schnittdarstellung (Figur 5) ist zu erkennen, daß das Kondensatorelement 7b aus der Kondensatoreinheit 7 herausragt und die halbkreisförmige Vertiefung 23 des ersten Gehäuseteiles 1 zur Wärmeabfuhr flächig berührt. Auch hier ist ein zwischen Kondensatorelement 7b und der Vertiefung angeordneter Wärmeleitkleber sinnvoll. Die Leitbleche 30, 31 verbinden die einzelnen Kondensatorelement 7a bis 7g mit den Stekkerelementen 16 und 17.

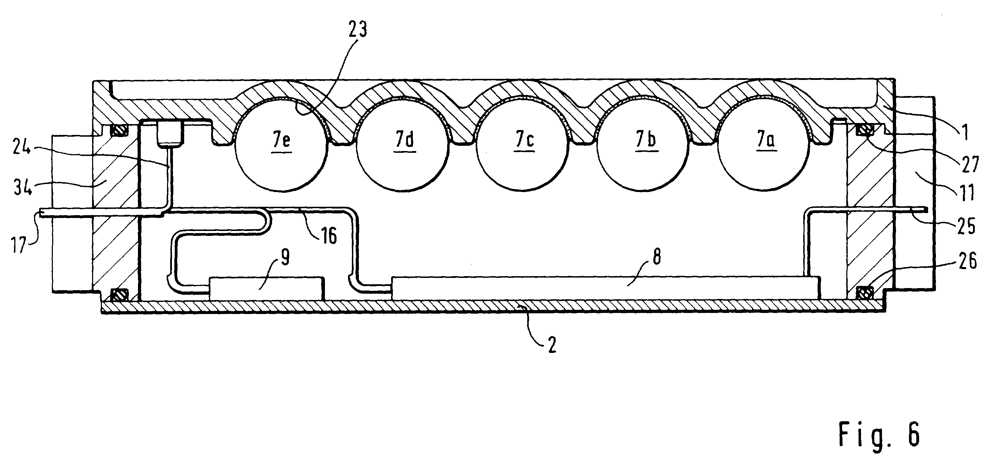

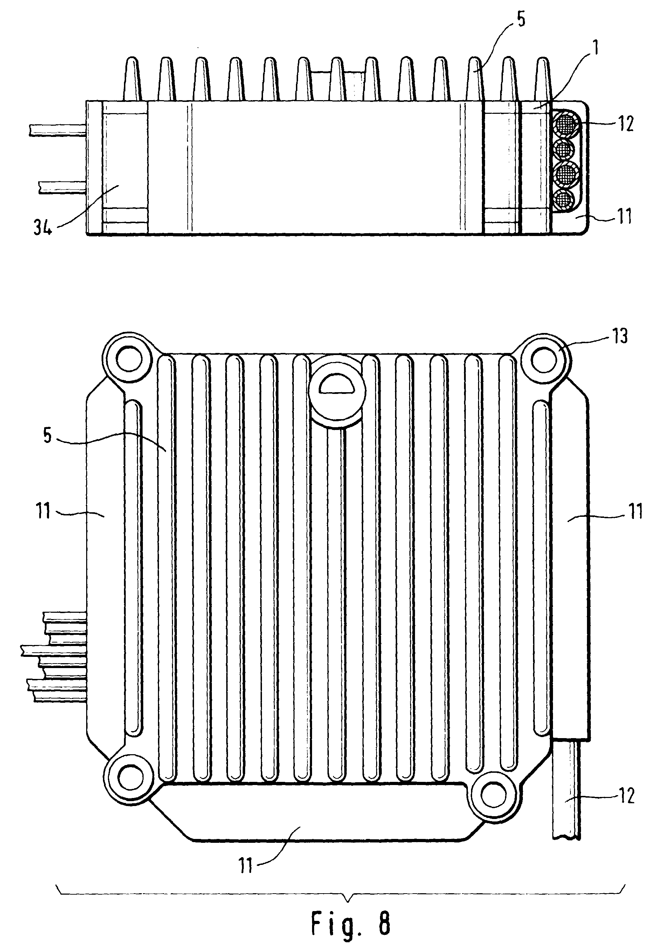

In Figur 6 ist eine weitere Ausführungsform der Erfindung dargestellt. Auch hierbei besteht das Gehäuse aus zwei Teilen, wobei die Gehäuseteile 1 und 2 plattenähnlich ausgeführt sind. Das Gehäuseteil 2 ist als Hybridschaltung mit der Mikroprozessorschaltung 8 und den Leistungsendstufen 9 ausgebildet. Auf den jeweiligen seitlichen Enden des Gehäuseteiles 2 ist umlaufend ein Hybridrahmen 34 angeordnet, welcher an seiner Außenseite die Kabelführung 11 aufweist, in dem das Kabel 12 angeschlossen ist (Figur 8). Die sich auf einer Seite durch den Hybridrahmen 34 erstreckenden Steckerelemente 16 und 17 sind dabei innerhalb des Gehäuses mit der Leistungsendstufe 9 bzw. mit dem Prozessorhybrid 8 verbunden. Auf dem Hybridrahmen 34 liegt das erste Gehäuseteil 1 auf. Dabei wird der Hybridrahmen 34 mit Hilfe je einer umlaufenden Dichtung 26, 27 gegen die Umwelt abgedichtet. Die Versorgungsspannung ist über den Steckerpin 25 auf die Leistungselektronik geführt.

Das Gehäuseteil 1 weist auf seiner der Elektronik 8, 9 zugewandten Seite Ausnehmungen 23 auf, welche in gleichmäßigen Abständen über die gesamte Oberfläche des Teiles 1 verteilt sind. In je eine solche Ausnehmung 23 ist ein Kondensator 7a bis 7e eingelegt, wobei die Form der Ausnehmung der Außenfläche des Kondensators 7a bis 7e angepaßt ist. Im gezeigten Beispiel ist die Ausnehmung 23 halbkreisförmig gestaltet. Über einen Steckerpin 24 des Hybridrahmens 34 wird die Kondensatoreinheit 7 mit Spannung versorgt.

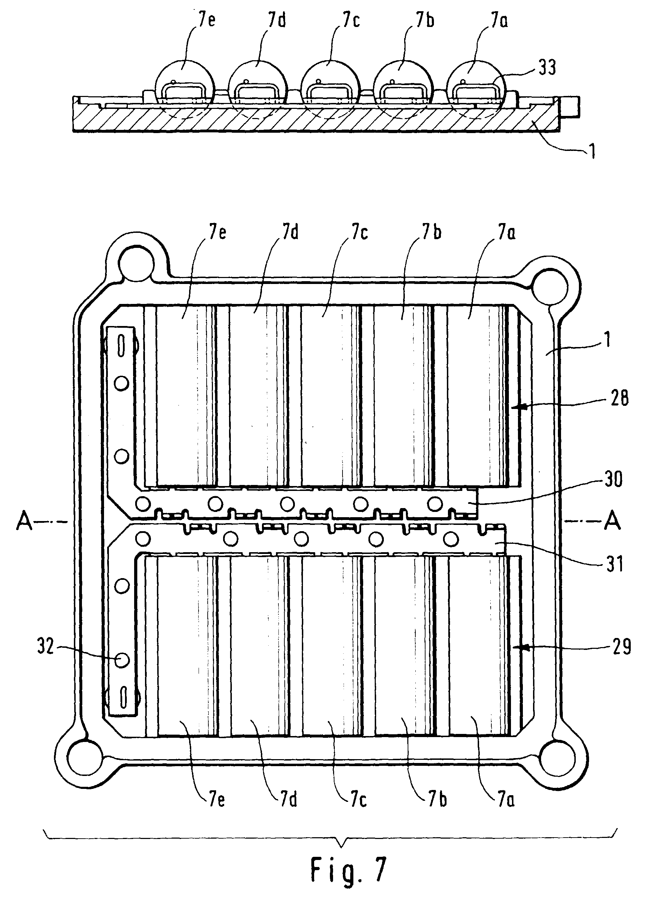

In Figur 7 ist eine Draufsicht auf das Gehäuseteil 1 mit den Kondensatoren 7a bis 7e dargestellt, wie sie sich aus dem Gehäuseinneren ergibt. Es sind jeweils 5 Kondensatoren 7a, 7b, 7c, 7d, 7e parallel nebeneinander in der in Figur 6 dargestellten Art und Weise angeordnet. Die so angeordneten Kondensatoren bilden zwei nebeneinander liegende Reihen 28 und 29.

Diese beiden Bereiche 28, 29 sind durch zwei Leitbleche 30, 31 getrennt. Dabei ist jedes Leitblech L-förmig ausgebildet und schließt mit seinen Schenkeln je eine Kondensatoreinheit 28 bzw. 29 annähernd rechtwinklig ein. Dabei ist das Leitblech 30 an die Versorgungsspannung und das Leitblech 31 an die Masse des Gerätes angeschlossen. An den Punkten 32 sind die Leitbleche 30, 31 mit dem Gehäuseteil 1 verstemmt. Wie aus dem Schnitt entsprechend der Linie A-A zu ersehen ist, sind die beiden, unterschiedliche Potentiale führenden Bleche 30, 31 über Kontaktbrücken 33 verbunden und bilden dabei gleichzeitig die elektrische Verbindung zu den Kondensatoren 7a bis 7e, welche in diese Kontaktbrücken 33 eingelegt und verlötet werden. Alternativ dazu können die Kondensatoren 7a bis 7e mittels einer Schneidklemmtechnik in die Kontaktbrücken 33 eingefügt werden.

In Figur 8 ist die Außenansicht des als Aluminiumdeckel ausgebildeten ersten Gehäuseteils 1 in Draufsicht dargestellt. Dabei sind noch einmal die Kühlrippen 5 verdeutlicht. Die beiden Gehäuseteile werden über eine Schraub- oder eine Nietvorrichtung 13 miteinander verbunden. Zwischen den beiden Gehäuseteilen 1 und 2 ist der Hybridrahmen 34 angeordnet, welcher an seinen Außenseiten Kabelführungen 11 aufweist. Bei der Montage des Hybridrahmens 34 mit dem ersten Gehäuseteil 1 wird der Kondensator 7 gegen das, den Kühlkörper bildende Gehäuseteil 1 gedrückt.

Bei dem beschriebenen Anwendungsfall treten Ströme bis zu 100 Ampere auf die Kondensatoren 7 haben dabei einen Kapazität von annähernd 3000 bis 4000 µF, um einen zuverlässigen EMV-Schutz der Schaltungsanordnung sowohl gegen intern im Gehäuse erzeugte als auch gegen von außen einwirkende Störsignale zu gewährleisten.

### Bezugszeichen

- 1: erstes Gehäuseteil
- 2: zweites Gehäuseteil
- 3: Hybridschaltung
- 4: Kühlkörper des zweiten Gehäuseteiles
- 5: Kühlkörper des ersten Gehäuseteiles
- 6: Steckereinrichtung
- 7: Kondensatoreinheit
- 7a - 7g: Kondensatorelemente
- 8: Leistungselektronik
- 9: Steuerelektronik
- 10: Steckerkörper
- 11: Kabelführung für Versorgungsspannung
- 12: Elektrische Leitung
- 13: Schraubeinrichtung
- 14: Ausnehmung
- 15: Steckereinlaß
- 16: Steckerelement
- 17: Steckerelement
- 18: Bondfläche
- 19: Kontakteinrichtung des Kondensators 7
- 20: Schweißstellen des Kondensators 7
- 21: Wärmeleitkleber
- 22: Feder
- 23: Ausnehmung
- 24: Steckerpin
- 25: Steckerpin
- 26: Dichtung
- 27: Dichtung
- 28: Bereich mit fünf Kondensatoren
- 29: Bereich mit fünf Kondensatoren
- 30: Leitblech
- 31: Leitblech
- 32: Niet
- 33: Kontaktbrücke
- 34: Hybridrahmen
- 35: Z-Diode
- 36: Nietverbindung

## Patentansprüche

1. Elektronische Einrichtung für ein Kraftfahrzeug, welche in einem zweiteiligen Gehäuse eine zum Schalten hoher Ströme ausgebildete Elektronikeinheit aufweist, wobei zur Unterdrückung der dadurch hervorgerufenen Störsignale eine Kondensatoreinheit im Gehäuse angeordnet ist, **dadurch gekennzeichnet**, daß die großflächig ausgebildete Kondensatoreinheit (7) wärmetechnisch mit einem ersten Gehäuseteil (1) und die Elektronikeinheit (8, 9) wärmetechnisch mit einem zweiten Gehäuseteil (2) verbunden ist.

2. Elektronische Einrichtung nach Anspruch 1, **dadurch gekennzeichnet**, daß die Kondensatoreinheit (7) in eine modulartig ausgebildete Steckereinheit (6) einlegbar ist, welche an dem ersten Gehäuseteil (1) befestigt ist.

3. Elektronische Einrichtung nach Anspruch 2, **dadurch gekennzeichnet**, daß die Kondensatoreinheit (7) durch ein sich an dem zweiten Gehäuseteil (2) abstützendes Federelement (22) gegen das erste Gehäuseteil (1) vorgespannt ist.

4. Elektronische Einrichtung nach Anspruch 1, **dadurch gekennzeichnet**, daß die Steckereinheit (6) und die Kondensatoreinheit (7) unabhängig voneinander an dem zweiten Gehäuseteil mechanisch befestigt sind.

5. Elektronische Einrichtung nach Anspruch 3 oder 4, **dadurch gekennzeichnet**, daß eine Wärmeleitkleberschicht (21) zwischen der Kondensatoreinheit (7) und dem ersten Gehäuseteil (1) angeordnet ist.

6. Elektronische Einrichtung nach Anspruch 2 oder 4, **dadurch gekennzeichnet**, daß nach außen geführte, einstückig ausgebildete Kontaktelemente (16, 17) der Steckereinheit (6) unterhalb der Kondensatoreinheit (7) verlaufen und an einer, dem Gehäuseinnenraum zugewandten Bondfläche (18) mit den elektrischen Anschlüssen der Elektronikeinheit (8, 9) verbindbar sind.

7. Elektronische Einrichtung nach Anspruch 1 und 6, **dadurch gekennzeichnet**, daß die Elektronikeinheit (8, 9) zur wärmemäßigen Entkopplung auf dem zweiten, plattenähnlich gestalteten Gehäuseteil (2) flächig aufliegt.

8. Elektronische Einrichtung nach einem der vorhergehenden Ansprüche, **dadurch gekennzeichnet**, daß beide Gehäuseteile (1, 2) eine rippenähnliche Außenoberfläche (4, 5) aufweisen, die unterschiedlich stark ausgeprägt ist.

9. Elektronische Einrichtung nach Anspruch 1, **dadurch gekennzeichnet**, daß das erste Gehäuseteil (1) zur Aufnahme der die Kondensatoreinheit (7) bildenden einzelnen Kondensatoretemente (7a, 7b, 7c, 7d, 7e) ausgebildet ist.

10. Elektronische Einrichtung nach Anspruch 9, **dadurch gekennzeichnet**, daß die lnnenflächen des ersten Gehäuseteiles (1) der Außenkontur der Kondensatorelemente (7a, 7b, 7c, 7d, 7e) entsprechende halbkreisförmige Vertiefungen (23) aufweist.

11. Elektronische Einrichtung nach Anspruch 9 oder 10, **dadurch gekennzeichnet**, daß die Kondensatorelemente (7a, 7b, 7c, 7d, 7e) zwei Bereiche (28, 29) bilden, die durch Leitbleche (30, 31) getrennt sind, die die Kondensatorelemente (7a, 7b, 7c, 7d, 7e) mit unterschiedlichen elektrischen Potentialen verbinden.

12. Elektronische Einrichtung nach Anspruch 11, **dadurch gekennzeichnet**, daß die Leitbleche annähernd L-förmig ausgebildet sind.

13. Elektronische Einrichtung nach einem der Ansprüche 9 bis 12, **dadurch gekennzeichnet**, daß das erste Gehäuseteil (1) auf einem Hybridrahmen (34) aufliegt, welcher mit dem ersten, die Elektronikeinheit (8, 9) tragenden Gehäuseteil (1) formschlüssig verbunden ist.
